# EUROPÄISCHE PATENTSCHRIFT

(11) **EP 1 440 608 B1**
(45) Veröffentlichungstag und Bekanntmachung des Hinweises auf die Patenterteilung: **15.02.2006**
(21) Anmeldenummer: 02791655.0
(22) Anmeldetag: 30.10.2002
(51) Int. Cl.: H05K 3/28

(54) **VERFAHREN ZUM OFFNEN EINES KUNSTSTOFFGEHAUSES EINER ELEKTRONISCHEN BAUGRUPPE**
METHOD FOR OPENING THE PLASTIC HOUSING OF AN ELECTRONIC MODULE
PROCEDE POUR OUVRIR LE BOITIER EN PLASTIQUE D'UN MODULE ELECTRONIQUE

(30) Priorität: 02.11.2001 DE 10154017; 02.11.2001 DE 10154021
(43) Veröffentlichungstag der Anmeldung: 28.07.2004
(73) Patentinhaber: ATMEL Germany GmbH, 74072 Heilbronn (DE)
(72) Erfinder: BURGER, Klaus, 71278 Weissach (DE); MUTZ, Dieter, 74078 Heilbronn (DE); ZIEGLER, Steffen, 74189 Weinsberg (DE)
(86) Internationale Anmeldenummer: PCT/EP2002/012096
(87) Internationale Veröffentlichungsnummer: WO 2003/039217

(56) Entgegenhaltungen:
- EP-A- 0 694 975
- WO-A-01/54853
- US-A- 5 616 524

## Beschreibung

Die vorliegende Erfindung betrifft ein Verfahren zum Öffnen einer kunststoffgehäusten elektronischen Baugruppe des als Teil- oder Vollverguss ausgebildeten Gehäuses.

Im Allgemeinen werden Verfahren zum Öffnen einer elektronischen Baugruppe, wie beispielsweise einer integrierten Schaltung, dazu benutzt elektrische Parameter der eingegossenen Baugruppe zu kontrollieren. Eine weitere wichtige Anwendung der Messverfahren liegt im Bereich der Reklamationsbearbeitung, um die Ursache einer elektrischen Fehlfunktion zu finden und insbesondere die Zuverlässigkeit des Vergussprozesses der elektronischen Baugruppe zu untersuchen. Hierbei ist es vorteilhaft, die Gehäuse einer elektronischen Baugruppe zu öffnen und elektrische Messungen an Kontaktflächen durchzuführen, die innerhalb des Gehäuses liegen. Hierzu ist es notwendig, die Vergussmassen der Kunststoffgehäuse, die sowohl unterschiedliche Bindemittel als auch verschiedene Füllstoffe aufweisen, selektiv, d.h. ohne Beschädigung der innenliegenden elektronischen Baugruppe, zu öffnen. Nachfolgend läßt sich beispielsweise eine Delamination zwischen der Verbindung eines Anschlußdrahtes (Bond) und einer in dem Gehäuse liegenden Kontaktfläche bestimmen, oder durch eine elektrische Messung an denjenigen Kontaktflächen, die nicht durch Anschlussdrähte verbunden sind, die Funktion von Schaltungsblöcken einer integrierten Schaltung überprüfen. Zweck dieses Verfahrens ist es, insbesondere bei Reklamationen von Kunden die Ursache einer elektrischen Fehlfunktion zu finden. Dabei besteht die Schwierigkeit, daß bei der Öffnung des Gehäuses die elektrischen Parameter bei längerer Einwirkung des Laserstrahls auf die Oberfläche der elektronischen Baugruppe sich die elektrischen Parameter eventuell verändern.

Aufgabe der vorliegenden Erfindung ist es, das Kunststoffgehäuse einer vergossenen elektronischen Baugruppe weitestgehend automatisiert zu öffnen und insbesondere eine Zerstörung einer innenliegenden elektronischen Baugruppe zu vermeiden.

Die genannte Aufgabe wird durch die Merkmale des Patentanspruches 1 gelöst. Günstige Ausgestaltungsformen sind Gegenstand von Unteransprüchen.

Hiernach besteht das Wesen der Erfindung darin, daß ein Gehäuse selektiv zu der elektronischen Baugruppe geöffnet wird, um an der innenliegenden Baugruppe Messungen durchzuführen. Hierzu wird mittels eines Laserstrahls an einem als Teil- oder Vollverguß hergestellten Gehäuse aus Kunststoff, das wenigstens eine in dem Verguß liegende elektrische Kontaktfläche und eine aus dem Verguss herausgeführte Anschlussleitung aufweist, zum Freilegen der Kontaktfläche ein Teil des Vergusses entfernt wird, solange bis ein Endpunkt detektiert wird.

Ein Vorteil des Verfahrens ist es, dass mit Hilfe der Dedektion des Endpunktes sich das Gehäuse einer elektronischen Baugruppe selektiv zu der elektronischen Baugruppe mittels eines Laserstrahls öffnen läßt, ohne dabei die kunststoffgehäuste elektronische Baugruppe zu beschädigen und dadurch elektrische Parameter ungewollt zu verändern. Hierbei läßt sich der Endpunkt sowohl aus der Analyse der chemischen Zusammensetzung des verdampfenden Materials als auch mittels einer optischen Messung beispielsweise durch Bestimmung des Reflektions - und oder des Absorptionsverhaltens gewinnen, wobei sich insbesondere durch das Freilegen von metallischen Kontaktflächen die optischen Eigenschaften in dem zu öffnenden Bereich stark ändern und sich mittels einer optischen Messung das Endpunktsignal besonders zuverlässig erzeugen läßt Ferner läßt sich durch eine Nachlaufzeit nach der Detektion des Endpunktes die Zuverlässigkeit des Verfahrens erhöhen, wobei es vorteilhaft ist, die Leistung des Laserstrahls zu reduzieren.

In einer Weiterbildung wird der Endpunkt mittels einer Schutzschicht erzeugt, welches die Entfernung der Vergussmasse beendet. Um Residuen der Vergussmasse auf der Schutzschicht zu vermeiden ist es vorteilhaft, nach der Detektion des Endpunktes den Laserstrahl erst nach einer Nachlaufzeit, in der die Leistung des Laserstrahls vorzugsweise verringert wird, abzuschalten. Ferner läßt sich das Endpunktsignal sowohl aus einer Änderung der chemischen Zusammensetzung als auch einer Dichteänderung des verdampfenden Materials erzeugen, wobei sich die Änderung der chemischen Zusammensetzung mittels einer spektroskopischen Analyse des verdampfenden Materials detektieren läßt. Des Weiteren lässt sich das Endpunktsignal durch eine optische Kontrolle mittels eines Photodetektors erzeugen, wobei sich insbesondere bei einer opaken Schutzschicht eine Änderung der Kontrastverhältnisse, die beispielsweise von metallisierten Bereichen erzeugt wird, auswerten läßt.

Ein weiterer Vorteil des Öffnens des Kunstoffgehäuses, das eine Schutzschicht aufweist, besteht darin, daß sich durch die Schutzschicht Kunststoffgehäuse mit unterschiedlichen chemischen Zusammensetzungen, insbesondere auch solche Verbindungen, bei denen andere Bindemittel oder alternative Füllstoffe verwendet werden, die elektronische Baugruppe vor einer Beschädigung zuverlässig geschützt wird. Hierbei wird durch die Energie des Laserstrahls der Kunststoff des Gehäuses verdampft, wobei die Vergussmasse eine hohe Abtragsrate und die Schutzschicht eine geringe Abtragsrate aufweist, sodaß sich nach einer vorgegebenen Zeit, die mittels einer Referenzbildung ermittelt wird, die Öffnung des Gehäuses beendet läßt. Untersuchungen der Anmelderin haben gezeigt, daß sich die Selektivität in der Abtragsrate zwischen der Schutzschicht und der Vergussmasse aus den Unterschieden in den optischen Eigenschaften im Bereich der Laserwellenlänge, den Unterschieden in den Schmelzpunkten und den Unterschieden in den Verdampfungstemperaturen bestimmt. Ferner läßt sich als Schutzschicht sowohl eine Einstoffschicht als auch eine Mehrstoffschicht verwenden, die aus organischen oder anorganischen Verbindungen bestehen. Beispielsweise läßt sich als organische Schutzschicht Polyimide oder Siloxane und als anorganische Schutzschicht Nitrid- und oder Oxidschichten, sowie dünne strukturierte Metallschichten verwenden. Um die Herstellungskosten der Schutzschicht zu reduzieren, ist es vorteilhaft, die Aufbringung der Schutzschicht in den Herstellungsprozesses der elektronischen Baugruppe, wie beispielsweise bei der Herstellung einer integrierten Schaltung, zu integrieren. Hierzu wird am Ende des Herstellungsprozesses bei der integrierten Schaltung die Schutzschicht aufgebracht, wobei Untersuchungen der Anmelderin gezeigt haben, daß sich die elektronische Baugruppe mit Schichtdicken im Bereich wenigen µm zuverlässig schützen läßt. Insbesondere läßt sich das Verfahren vorteilhaft zur Fehlersuche bei vergossenen elektronischen Schaltungen anwenden. Hierzu wird die Vergussmasse bis zur Schutzschicht entfernt und anschließend beispielsweise an einem Spitzenmeßplatz die Leiterbahnen ohne Entfernung der Schutzschicht kontaktiert, um die elektrische Funktion einzelner Schaltungsblöcke zu überprüfen. Eine Fehlersuche wird damit erheblich beschleunigt Ferner lassen sich gleichartige Gehäuse automatisiert öffnen, indem die Verfahrensparameter beim Öffnen eines vorangegangenen Gehäuses als Referenz abgespeichert werden.

In einer anderen Weiterbildung des Verfahrens wird zur Erzeugung des Endpunktsignals die Absorptionskonstante der Schutzschicht kleiner als die Absorptionskonstante der Vergussmasse eingestellt, indem unterschiedliche Bindemittel und Zuschlagsstoffe verwendet werden. Hierbei wird die Erzeugung des Endpunktsignals mittels des optischen Detektors wesentlich vereinfacht Ferner weist die Vergussmasse im Vergleich zu der Schutzschicht eine höhere Abtragsrate auf, da die Energieaufnahme der Schicht proportional zu deren Absorptionskonstante ist In einer anderen Weiterbildung des Verfahrens wird zur Gewinnung eines Endpunktsignals eine erhöhte Reflektion an der Schutzschicht erzeugt, indem der Brechungsindex der Schutzschicht im Vergleich zu der Vergußmasse erhöht wird. Die Größe der Reflektion wird durch den optischen Detektor gemessen und oberhalb eines vorgegebenen Wertes ein Endpunkt angezeigt.

In einer Weiterbildung des Verfahrens wird die Schutzschicht mittels eines Maskenschrittes strukturiert Insbesondere bei einer Integration der Schutzschicht, die beispielsweise aus Polyimid bestehen, in den Fertigungsprozess einer integrierten Schaltung ist es vorteilhaft, die Strukturierung mit einer Kontaktfenstermaske und mittels eines kostengünstigen nasschemischen Prozesses durchzuführen. Durch die Entfernung der Schutzschicht in den Bereichen der Kontaktfenster läßt sich die Schutzschicht vor dem Verbinden der Anschlußdrähte (Bonden) aufbringen. Ferner sind beim Öffnen des Vergusses mittels des Lasers auf den Kontaktflächen keine Schutzschicht. Hierdurch lassen sich die Kontaktflächen bei elektrischen Messungen einfacher kontaktieren.

In einer anderen Weiterbildung des Verfahrens läßt sich durch eine Nachlaufzeit nach der Detektion des Endpunktes die Zuverlässigkeit des Verfahrens erhöhen, wobei es vorteilhaft ist, die Leistung des Laserstrahls während der Nachlaufzeit zu reduzieren.

Andere Untersuchungen der Anmelderin haben gezeigt, daß es vorteilhaft ist, vor der elektrischen Messung, Reste der Vergussmasse durch einen nasschemischen Prozessschritt zu entfernen. Hierbei lassen sich die Kontaktwiderstände bei einer elektrischen Kontaktierung verringern und die Oberfläche von vorhandenen leitfähigen Kohlenstoffverbindungen, die sich bevorzugt bei hohen Leistungen des Laserstrahls ergeben, entfernen.

In einer anderen Weiterbildung des Verfahrens wird die Schutzschicht nasschemisch entfernt. Insbesondere bei ganzflächigen Schutzschichten, die die Anschlußflächen der elektronischen Baugruppe bedecken und nach dem Bonden aufgebracht werden, vereinfachen sich durch die Entfernung der Schutzschicht die weiteren Analyseschritte. Ferner lassen sich durch den nasschemischen Reinigungsschritt auch Reste der Vergussmasse entfernen. Hierbei verringern sich die Kontaktwiderstände bei einer elektrischen Kontaktierung und die Oberfläche wird von vorhandenen leitfähigen Kohlenstoffverbindungen, die sich bevorzugt bei hohen Leistungen des Laserstrahls ergeben, gereinigt.

Das erfindungsgemäße Verfahren soll nachfolgend anhand von Ausführungsbeispielen im Zusammenhang mit schematisierten Zeichnungen erläutert werden. Es zeigen, die
- Fig. 1: eine elektronischen Baugruppe die bei der Öffnung des Gehäuses mittels einer Schutzschicht geschützt wird, und
- Fig. 2: eine freigelaserte integrierte Schaltung.

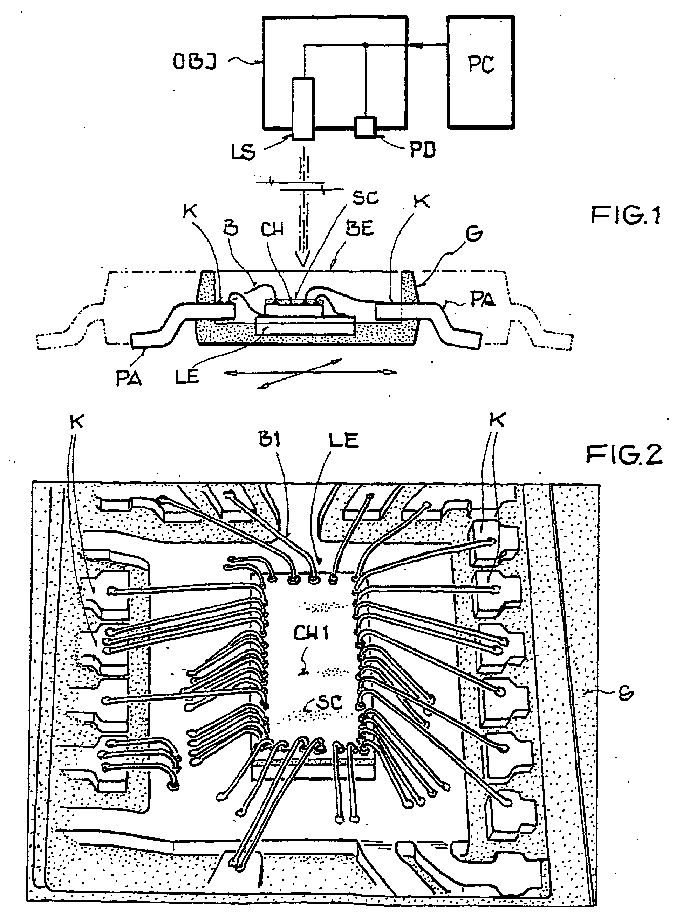

In der Figur 1 ist dargestellte Vorrichtung weist eine optische Einheit OBJ mit einem Laser LS1, der eine im infraroten Spektralbereich liegende Wellenlänge aufweist, auf. Der Laserstrahl des Lasers LS1 wird mittels einer umlaufenden Blende (nicht abgebildet) in kurze Laserimpulse zerhackt Hierbei bestimmt die Geschwindigkeit der umlaufenden Blende die Dauer der Laserimpulse des Lasers LS1. Des Weiteren weist die optische Einheit OBJ für eine Detektion einer Kontraständerung einen optischen Detektor PD auf. Ferner ist die optische Einheit OBJ zur Steuerung mit einem Personalcomputer PC verbunden. Von der optischen Einheit OBJ wird der Laserstrahl des Lasers LS1 auf die Oberfläche eines in einem als Vollverguss ausgebildeten Kunststoffgehäuses G abgebildet, wobei sich mittels einer Spiegel- und Linsenanordnung die Brennweite und die Auslenkung des Laserstrahls des Lasers LS1 auf der Oberfläche des Kunststoffgehäuses G verschieben lässt. Ferner ist in dem Kunststoffgehäuse G eine elektronische Baugruppe CH, die mittels Anschlussdrähten B auf einen Metallstreifen LE und mit Anschlußpins PA kontaktiert ist, eingegossen. Ferner weist die elektronische Baugruppe CH an der Oberfläche eine strukturierte Schutzschicht SC aus Kunststoff auf, wobei die Dicke der Schutzschicht SC im Bereich von wenigen µm liegt. Hierbei wurde die Schutzschicht SC mittels einer Kontaktfenstermaske strukturiert, d.h. die Kontaktflächen der elektronischen Baugruppe CH enthalten keine Schutzschicht SC. Des Weiteren wird das Gehäuse G beim Öffnen mittels eines Unterdrucks an einer Auflageplatte (nicht abgebildet) fixiert.

Zur Öffnung des Kunststoffgehäuses G der elektronischen Baugruppe CH wird durch die optische Einheit OBJ, die von dem Personalcomputer PC gesteuert wird, ein zu öffnender Bereich BE auf der Oberfläche des Kunststoffgehäuses G definiert und die Koordinaten des Bereichs BE in dem Personalcomputer PC gespeichert. Nachfolgend wird innerhalb des Bereichs BE die Oberfläche des Gehäuses G mit dem Laser LS1, dessen Strahl pulsförmig ist, entlang einer zick-zack förmigen Linie überstrichen. Hierbei bestimmt die Pulsdauer und die Brennweite des Laserstrahls des Lasers LS1, die auf der Gehäuseoberfläche G auftreffende Energiemenge. Untersuchungen der Anmelderin haben gezeigt, daß sich bei einem pulsförmigen Laserstrahl durch eine Veränderung der Pulsdauer die Leistung des Laserstrahls an die chemische Zusammensetzung des Vergusses besonders einfach anpassen läßt, sodaß eine Ablagerung von leitfähigen Kohlenstoffverbindungen auf der Oberfläche des Gehäuses unterdrückt wird. Ferner wird von der Pulsdauer die Versatzgeschwindigkeit der Laserpulse entlang der zick-zack förmigen Linie bestimmt. Durch die Aneinanderreihung der Laserpulse entlang der zick-zack förmigen Linie wird der Kunststoff in dem Bereich BE schichtweise verdampft, wobei bei größerer Dicke der abzutragenden Kunststoffschicht der Bereich BE mehrfach entlang von zick-zack förmigen Linien durchfahren wird. Andere Untersuchungen der Anmelderin haben gezeigt, daß durch die Führung des Laserstrahls in einer zick-zack förmigen Linie ein besonders gleichmäßiger Abtrag erreicht wird und dadurch bereits eine dünne Schutzschicht die elektronische Baugruppe zuverlässig schützt. Hierbei ist es vorteilhaft, wenn der verdampfte Kunststoff während des Öffnens des Gehäuses abgesaugt wird und sich nicht auf der Oberfläche des Gehäuses G niederschlägt. Ferner wird das Öffnen mittels des optischen Detektors PD insbesondere auf eine Änderung der Kontrastverhältnisse kontrolliert. Untersuchungen der Anmelderin haben gezeigt, daß sich durch entsprechende Wahl der Parameter des Laserstrahls des Lasers LS1 der Kunststoff des Gehäuses G schnell bis auf die Schutzschicht SC, d.h. mit einer hohen Abtragsrate, entfernen läßt. Durch die anderen optischen Eigenschaften weist die Schutzschicht SC eine im Vergleich zu dem Vergussmaterial eine geringe Abtragsrate auf und erzeugt durch die geänderten Kontrastverhältnisse aufgrund der metallischen Kontaktflächen der elektronischen Baugruppe CH im optischen Detektor PD ein Endpunktsignal. Das Öffnen wird beendet, sobald der Wert der Kontraständerung in dem geöffneten Bereich einen vorgegebenen Schwellwert übersteigt. Sofern der geöffnete Bereich BE Reste des Vergussmaterials aufweist, lassen sich diese in einem sogenannten Reinigungsschritt entfernen. Hierzu überstreicht der Laserstrahl während einer vorgegebenen Nachlaufzeit den zu öffnenden Bereich BE mit einer im Vergleich zu dem vorangegangenen Öffnungsschritt stark reduzierten Leistung. Sofern die Schutzschicht SC in dem geöffneten Bereich BE nachfolgende Analysen behindert, wird die Schutzschicht SC in einem nasschemischen Reinigungsschritt entfernt. Untersuchungen der Anmelderin haben gezeigt, daß sich mit dem nasschemischen Reinigungsschritt insbesondere hochohmige Nebenschlüsse auf der Oberfläche entfernen lassen und sich eine Extraktion von elektrischen Parametern beschleunigt

Ein Vorteil des Verfahrens ist es, daß sich mittels eines Laserstrahls der Kunststoff des Gehäuses selektiv zu der Schutzschicht SC verdampfen lässt und die elektronische Baugruppe CH zuverlässig vor der Einwirkung der Laserpulse geschützt und insbesondere die elektrischen Parameter der elektronischen Baugruppe nicht verändert werden. Durch die Schutzschicht SC in Verbindung mit dem Laserstrahl lassen sich die Gehäuse schnell öffnen, wobei sich durch die Endpunkterkennung das Öffnen automatisiert durchführen läßt Durch die nasschemische Reinigung wird die Oberfläche konditioniert, d.h. von Resten der verdampften Vergussmasse gereinigt Nachfolgende Analysen lassen sich schnell und kostengünstig durchführen. Untersuchungen der Anmelderin haben gezeigt, daß bei dem Öffnen unterschiedlicher Arten von Gehäusen die Leistung des Laserstrahls nur wenig von der chemischen Zusammensetzung bzw. dem Anteil an eingelagerten Fremdstoffen abhängt Ferner ist es wegen den Absorptionsspektren, der auf dem Gebiet der Gehäuse verwendeten Kunststoffe, vorteilhaft, eine Laser Wellenlänge im infraroten Spektralgebiet zum Öffnen des Vergusses einzusetzen, wobei durch eine geeignete Wahl von Leistung und Zeitdauer der Laserimpulse der Kunststoff des Gehäuses verdampft wird und eine Ausbreitung einer Wärmewelle in dem verbleibenden Kunststoff durch die dabei stattfindende Energieabsorption unterdrückt wird. Ferner lassen sich in einem Arbeitsgang der Verguß der gesamten elektronischen Baugruppe bis auf die Schutzschicht entfernen oder mehrere zu öffnende Bereiche festlegen, die beispielsweise in Summe nur einen Teil der Oberfläche des Gehäuses umfassen. Hierbei lassen sich die einzelnen Bereiche in unterschiedlicher Reihenfolge öffnen und zwischen den einzelnen Öffnungsschritten eine oder mehrere nasschemische Reinigungen und oder elektrische Messungen durchführen.

In Figur 2 ist eine elektronenmikroskopische Aufnahme eines Metallstreifens LE1 und einer darauf fixierten integrierten Schaltung CH1 abgebildet Der Kunststoff des Gehäuses wurde hierbei mit einem mehrfachen schichtweisen Abtrag mittels des Lasers selektiv der Schutzschicht SC entfernt. Ferner wurde in einem nachfolgenden Reinigungsschritt die Schutzschicht SC entfernt. An der freigelegten elektronischen Schaltung CH1 lassen sich durch Kontaktierung einzelner Leiterbahnen und Kontaktflächen, die nicht mittels Anschlussdrähten verbunden sind, die elektrischen Funktionen einzelner Schaltungsblöcke überprüfen die im vergossenen Zustand nicht zugänglich sind. Ferner lassen sich weitere Analysen wie beispielsweise eine optische Kontrolle durchführen.

## Patentansprüche

1. Verfahren zum Öffnen einer kunststoffgehäusten elektronischen Baugruppe (CH) in einem als Teil- oder Vollverguss hergestellten Gehäuse (G) aus Kunststoff mit wenigstens einer in dem Verguß Ilegenden elektrischen Kontaktfläche (K) und aus dem Verguss herausgeführten Anschlussleitungen,
**dadurch gekennzeichnet, daß**
• zum Freilegen der Kontaktfläche (K) mittels eines. Laserstrahls ein Teil des Vergusses entfernt wird, und
• mittels einer auf der Oberfläche der elektronischen Baugruppe liegenden Schutzschicht (SC) ein Endpunktsignal erzeugt wird, und
• die Entfernung des Vergusses durch den Laserstrahl mittels eines Endpunktsignals beendet wird.

2. Verfahren nach Anspruch 1, bei dem die Absorptionskonstante der Schutzschicht (SC) kleiner als die Absorptionskonstante des Vergusses ist.

3. Verfahren nach einem der Ansprüche 1 bis 2, bei dem an der Schutzschicht (SC) wenigstens ein Teil des Laserstrahls reflektiert wird.

4. Verfahren nach einem der Ansprüche 1 bis 3, bei dem die Schutzschicht (SC) vor dem Aufbringen der Vergussmasse strukturiert wird.

5. Verfahren nach einem der Ansprüche 1 bis 4, bei dem nach einer Detektion des Endpunktsignals während einer vorgegebenen Nachlaufzeit eine weitere Entfernung der Schutzschicht und oder des Vergusses mittels des Laserstrahls durchgeführt wird.

6. Verfahren nach einem der Ansprüche 1 bis 5, bei dem die Schutzschicht (SC) nasschemisch entfernt wird.

## Claims

1. Method of opening an electronic subassembly (CH), which is encased in plastics material, in a casing (G), which is produced as a partial or solid casting, of plastics material with at least one electrical contact surface (K) disposed in the casting and connecting lines led out of the casting, **characterised in that**
- for exposing the contact surface (K) a part of the casting is removed by means of a laser beam,
- an end point signal is produced by means of a protective layer (SC) lying on the surface of the electronic subassembly and
- removal of the casting by the laser beam is concluded by means of an end point signal.

2. Method according to claim 1, in which the absorption constant of the protective layer (SC) is smaller than the absorption constant of the casting.

3. Method according to one of claims 1 and 2, in which at least a part of the laser beam is reflected at the protective layer (SC).

4. Method according to one of claims 1 to 3, in which the protective layer (SC) is structured before application of the casting mass.

5. Method according to one of claims 1 to 4, in which after detection of the end point signal a further removal of the protective layer and/or the casting is undertaken by means of the laser beam for a predetermined run-on time.

6. Method according to one of claims 1 to 5, in which the protective layer (SC) is removed by a wet-chemical method.

## Revendications

1. Procédé pour l'ouverture d'un module (CH) électronique à boîtier en matière plastique contenu dans un boîtier (G) scellé partiellement ou totalement dans une matière plastique et présentant au moins une surface de contact (K) électrique disposée dans le scellement ainsi que des conduits de connexion sortant du scellement,
**caractérisé en ce que**
• pour dégager la surface de contact (K) au moyen d'une rayon laser, on enlève une partie du scellement, et
• l'on génère un signal d'extrémité terminale au moyen d'une couche protectrice (SC) située à la surface du module électronique, et
• l'on arrête l'enlèvement du scellement par le rayon laser au moyen d'un signal d'extrémité terminale.

2. Procédé selon la revendication 1, dans lequel le coefficient d'absorption de la couche protectrice (SC) est inférieure au coefficient d'absorption du scellement.

3. Procédé selon l'une quelconque des revendications 1 à 2, dans lequel au moins une partie du rayon laser est réfléchie sur la couche protectrice.

4. Procédé selon l'une quelconque des revendications 1 à 3, dans lequel on structure la couche protectrice (SC) avant d'appliquer la masse de scellement.

5. Procédé selon l'une quelconque des revendications 1 à 4, dans lequel on procède, après détection du signal d'extrémité terminale, pendant une durée de poursuite prédéfinie, à un enlèvement supplémentaire de la couche protectrice et ou du scellement au moyen du rayon laser.

6. Procédé selon l'une quelconque des revendications 1 à 5, dans lequel la couche protectrice (SC) est enlevée par voie chimique humide.
